Europäisches Patentamt

European Patent Office

Office européen des brevets

(19)

(11) Veröffentlichungsnummer: **0 009 125**
A1

# (12) EUROPÄISCHE PATENTANMELDUNG

(21) Anmeldenummer: **79103020.8**

(22) Anmeldetag: **17.08.79**

(51) Int. Cl.³: **H 01 L 23/28**
/ / H01L21/316

(30) Priorität: **19.09.78 DE 2840776**

(43) Veröffentlichungstag der Anmeldung: **02.04.80**
**Patentblatt 80/7**

(84) Benannte Vertragsstaaten: **FR GB IT**

(71) Anmelder: **SIEMENS AKTIENGESELLSCHAFT Berlin**
**und München, Postfach 22 02 61, D-8000**
**München 22 (DE)**

(72) Erfinder: **Schnöller, Manfred, Dr. rer. nat., Dipl.-Chem.,**
**Grete-Hoffmann-Weg 24, D-8041 Haimhausen (DE)**

(54) **Halbleiterbauelement mit passivierender Schutzschicht.**

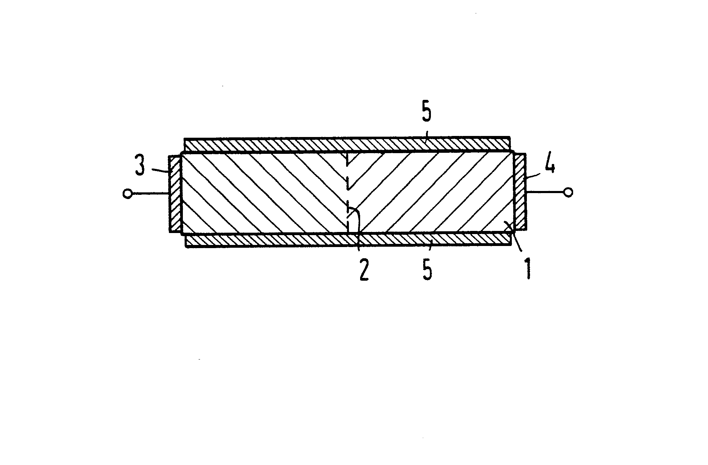

(57) Zur Stabilisierung der Sperrkennlinien von Halbleiterbauelementen wird vorgeschlagen, auf die Oberfläche der
Halbleiterkörper (1) eine im Vakuum aufgedampfte Schicht
(5) eines Siliciumoxids der Formel $SiO_{\bar{x}}$ aufzubringen. Der
spezifische Widerstand dieser Schicht (5) liegt so hoch,
daß sie eine ausreichende Stabilität der Kennlinien auch
ohne Nachbehandlung, zum Beispiel durch Temperatureinwirkung, gewährleistet. Die passivierende Schutzschicht
kann bei allen Arten von Halbleiterbauelementen verwendet
werden (Fig. 1).

SIEMENS AKTIENGESELLSCHAFT          Unser Zeichen
Berlin und München                  VPA
                                    78 P 1 1 7 2 EUR

Halbleiterbauelement mit passivierender Schutzschicht

Die Erfindung bezieht sich auf ein Halbleiterbauelement, das ein aus Silicium bestehendes Halbleiterelement mit mindestens einem pn-Übergang aufweist, mit einer im Vakuum aufgedampften, Silicium enthaltenden Passivierungsschicht, die das Halbleiterelement mindestens
dort bedeckt, wo der pn-Übergang an die Oberfläche des
Halbleiterelementes tritt.

Ein solches Halbleiterbauelement ist bereits beschrieben worden. Die Passivierungsschicht wird bei diesem
Halbleiterbauelement durch im Vakuum aufgedampftes Silicium erzeugt, das sich auf der Oberfläche des Halbleiterelementes in amorpher Form niederschlägt. Der Zweck
dieser Passivierungsschicht ist, die Sperrkennlinien
des Halbleiterbauelementes stabil zu halten. Dabei soll
der Sperrstrom auf niedrigem Niveau stabilisiert werden.

Hab 1 Dx / 18.09.1978

Halbleiterbauelemente, die mit einer Passivierungsschicht aus aufgedampftem, amorphem Silicium versehen waren, zeigten zwar im allgemeinen die erwünschte Stabilität der Sperrkennlinien, jedoch waren die Sperrströme um mindestens eine Zehnerpotenz zu hoch. Es ist bereits vorgeschlagen worden, eine solche Passivierungsschicht aus aufgedampftem, amorphem Silicium anschließend insbesondere unter Sauerstoffpartialdruck zu tempern. Damit ist jedoch ein zusätzlicher Arbeitsgang erforderlich.

Der Erfindung liegt die Aufgabe zugrunde, eine Schicht der eingangs genannten Art zur Erzielung stabiler Sperrkennlinien so weiterzubilden, daß ein Tempern überflüssig wird.

Die Erfindung ist dadurch gekennzeichnet, daß die Passivierungsschicht aus Siliciumoxid der Formel $SiO_x$ be-steht. Der Wert x kann dabei zwischen 0,1 und 2 liegen.

Die Passivierungsschicht kann aus Siliciummonoxid SiO oder auch aus Siliciumdioxid $SiO_2$ bestehen. Zur Einstel-lung des spezifischen Widerstandes kann die Schicht Dotierstoffe oder auch Metalle enthalten. Zweckmäßigerweise sollte die Passivierungsschicht mindestens 0,05 µm dick sein.

Die Erfindung wird an Hand eines Ausführungsbeispiels in Verbindung mit der Figur näher erläutert:

In der Figur ist ein Halbleiterelement im Schnitt dargestellt. Das Halbleiterelement hat einen aus Silicium bestehenden Halbleiterkörper 1 und weist zwei Zonen entgegengesetzten Leitfähigkeitstyps auf, die durch einen pn-Übergang 2 getrennt sind. Das Halbleiterelement ist mit metallischen Elektroden 3, 4 versehen, die zur Zu- beziehungsweise Abführung des Stroms dienen. Das Halbleiterelement ist an seiner von den Elektroden 3, 4 nicht bedeckten Oberfläche von einer Passivierungsschicht 5 bedeckt. Diese Passivierungsschicht soll die Oberfläche des Halbleiterelementes 1 zumindest dort bedecken, wo der pn-Übergang 2 an die Oberfläche tritt. Die Passivierungsschicht 5 besteht aus im Vakuum aufgedampftem Siliciumoxid der Formel $SiO_x$. Dieses Siliciumoxid kann Siliciummonoxid SiO, Siliciumdioxid $SiO_2$ oder eine nichtstöchiometrische Verbindung von Silicium und Sauerstoff sein. Der Wert x kann dabei zwischen 0,1 und 2 liegen. Die Dicke der Passivierungsschicht 5 kann 0,05 /um oder mehr betragen. Zur Einstellung des spezifischen Widerstandes der Passivierungsschicht 5 können der Siliciumoxidschicht beim Aufdampfen Dotierstoffe oder auch Metalle beigegeben werden, die zweckmäßigerweise gleichzeitig mit dem Siliciumoxid aufgedampft werden. Als Dotierstoffe kommen beispielsweise Wasserstoff, Stickstoff oder Bor, Phosphor in Betracht. Als Metall kann zum Beispiel Aluminium verwendet werden.

Das Aufdampfen der Siliciumoxidschicht kann in einer handelsüblichen Vakuum-Bedampfungsanlage geschehen. Dazu wird beispielsweise ein Druck von $10^{-6}$ mbar eingestellt. Dann wird das in die Bedampfungsanlage eingebrachte Siliciumoxid zum Beispiel durch Erhitzen in einem Molybdänschiffchen mittels induktiver Heizung verdampft. Auch andere Arten der Erhitzung sind möglich. Dabei wurde eine Aufdampfrate von 1,5 nm/s erzielt. Die aufgedampfte Siliciumoxidschicht erreichte dabei einen spezifischen Widerstand von $10^{10}$ bis $10^{11}$ Ohm.cm. Der Wert x für das Siliciumoxid $SiO_x$ wurde zu 0,8 bestimmt.

0009125

Die Erfindung wurde an Hand eines einfachen Halbleiterelementes mit einem einzigen pn-Übergang erläutert. Es können jedoch auch Halbleiterelemente mit mehreren pn-Übergängen und integrierte Schaltkreise mit der beschriebenen Passivierungsschicht ausgestattet werden.

7 Patentansprüche
1 Figur

Patentansprüche

1. Halbleiterbauelement, das ein aus Silicium bestehendes Halbleiterelement mit mindestens einem pn-Übergang aufweist, mit einer im Vakuum aufgedampften, Silicium enthaltenden Passivierungsschicht, die das Halbleiterelement mindestens dort bedeckt, wo der pn-Übergang an die Oberfläche des Halbleiterelementes tritt, d a - d u r c h g e k e n n z e i c h n e t , daß die Passivierungsschicht (5) aus Siliciumoxid der Formel $SiO_x$ besteht.

2. Halbleiterbauelement nach Anspruch 1, d a d u r c h g e k e n n z e i c h n e t , daß der Wert x zwischen 0,1 und 2 liegt.

3. Halbleiterbauelement nach Anspruch 1, d a d u r c h g e k e n n z e i c h n e t , daß die Passivierungsschicht (5) aus Siliciummonoxid SiO besteht.

4. Halbleiterbauelement nach Anspruch 1, d a d u r c h g e k e n n z e i c h n e t , daß die Passivierungsschicht (5) aus Siliciumdioxid $SiO_2$ besteht.

5. Halbleiterbauelement nach einem der Ansprüche 1 bis 4, d a d u r c h g e k e n n z e i c h n e t , daß die Passivierungsschicht (5) Dotierstoffe enthält.

6. Halbleiterbauelement nach einem der Ansprüche 1 bis 5, d a d u r c h g e k e n n z e i c h n e t , daß die Passivierungsschicht (5) Metalle enthält.

7. Halbleiterbauelement nach einem der Ansprüche 1 bis 6, d a d u r c h  g e k e n n z e i c h n e t , daß die Passivierungsschicht (5) mindestens 0,05 $\mu$m dick ist.

0009125

Europäisches Patentamt

**EUROPÄISCHER RECHERCHENBERICHT**

0009125

Nummer der Anmeldung

EP 79 10 3020

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | US - A - 3 178 804 (UNITED AIR-CRAFT) <br> * Figur 10; Spalte 4, Zeilen 38-41 * <br> -- | 1,7 |
| | FR - A - 2 099 690 (UNITED KING-DOM ATOMIC ENERGY AUTHORITY) <br> * Ansprüche 1-3; Seite 5, Zeilen 17-26 * <br> & DE - A - 2 137 959 <br> -- | 1-4 |
| | GB - A - 1 193 310 (TEXAS) <br> * Anspruch 12; Seite 4, Zeilen 47-50 * <br> -- | 1,4,5 |
| | US - A - 3 489 658 (AVCO) <br> * Spalte 2, Zeilen 55-61 * <br> -- | 1,3,7 |
| | DE - A - 2 452 289 (SIEMENS) <br> * Ansprüche 1,4 * <br> -- | 1,4,6,7 |
| | DE - A - 2 202 319 (BBC) <br> * Anspruch 1 * <br> -- | 1,4,6 |
| | FR - A - 2 230 086 (CENTRE NATIONAL D'ETUDES SPATIALES) <br> * Anspruch 3 * <br> ---- | 1,4,6 |

**KLASSIFIKATION DER ANMELDUNG (Int.Cl. 3)**

H 01 L 23/28//
H 01 L 21/316

**RECHERCHIERTE SACHGEBIETE (Int. Cl. 3)**

H 01 L 23/28
21/56
21/316

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort <br> Den Haag | Abschlußdatum der Recherche <br> 12-12-1979 | Prüfer <br> DE RAEVE |
|---|---|---|

EPA form 1503.1  06.78